(19) Europäisches Patentamt
European Patent Office
Office européen des brevets

(11) **EP 2 492 786 A1**

(12) **EUROPÄISCHE PATENTANMELDUNG**

(43) Veröffentlichungstag:
**29.08.2012 Patentblatt 2012/35**

(51) Int Cl.:
***G06F 3/044*** *(2006.01)*     ***G06F 3/041*** *(2006.01)*

(21) Anmeldenummer: **11155357.4**

(22) Anmeldetag: **22.02.2011**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **RAFI GmbH & Co. KG
88276 Berg (DE)**

(72) Erfinder:
• **Bulach, Eric
88074 Meckenbeuren (DE)**
• **Seybold, Lothar
88276 Berg (DE)**

(74) Vertreter: **Engelhardt & Engelhardt
Montafonstraße 35
88045 Friedrichshafen (DE)**

(54) **Bedienelement**

(57)     Bei einem Bedienelement (1) zur Erzeugung eines elektrisch auswertbaren Schaltsignals (14), bestehend aus einem Gehäuserahmen (2), aus einer dünnwandigen Abdeckplatte (4), die in den Gehäuserahmen (2) eingesetzt und an diesem abgestützt ist, aus einer elektrisch betriebenen Auswerteeinrichtung (5, 5', 5") und aus mindestens einem der Abdeckplatte (4) zugewandten Sensor (6), der durch die Auswerteeinrichtung (5, 5', 5") überwacht ist und durch den ein kapazitives Feld (7) oder resistive Veränderung (8) erzeugt ist, das auf der Außenseite (10) der Abdeckplatte (4) gebildet ist, soll sowohl das die üblichen kapazitiven oder resistiven Bedienungen eines elektrischen Gerätes möglich sein und gleichzeitig soll gewährleistet sein, dass bestimmte sicherheitsrelevante Schaltfunktionen zuverlässig betätigt und ausgeführt werden.

    Dies wird dadurch erreicht, dass der Abdeckplatte (4) mindestens ein Schaltbereich (13) zugeordnet ist, der eine vorgegebene Schaltfunktion aufweist, dass zwischen dem Gehäuserahmen (2) und der diesem zugewandten Innenseite (10') der Abdeckplatte (4) mindestens eine Kraftmesseinrichtung (11) und/oder eine Wegmesseinrichtung (15) angeordnet ist, die elektrisch mit der Auswerteeinrichtung (5") derart verbunden ist bzw. sind, dass durch die Auswerteeinrichtung (5") feststellbar ist, an welcher Position der Abdeckplatte (4) eine Betätigung erfolgt und dass durch die Auswerteeinrichtung (5") über die Kraftmesseinrichtung (11) und/oder Wegmesseinrichtung (15) ermittelbar ist, welche Betätigungskraft an dieser Position auf die Abdeckplatte (4) einwirkt.

Figur 1a

EP 2 492 786 A1

**Beschreibung**

Die Erfindung bezieht sich auf ein Bedienelement zur Erzeugung eines elektrisch auswertbaren Schaltsignals nach dem Oberbegriff des Patentanspruches 1.

Beispielsweise aus der europäischen Patentanmeldung 10155169.5 ist ein kapazitiver Schalter zu entnehmen, durch den elektrisch auswertbare Schaltsignale generierbar sind. Dieser kapazitive Schalter besteht aus einer als integriertem Schaltkreis ausgebildeten Auswerteeinrichtung, aus einem elektrisch leitfähigen Material, beispielsweise einer Kupferschicht hergestellten Sensorfläche, durch die ein kapazitives Feld im Raum erzeugt ist, das die den Sensor nach außen verschließende Abdeckplatte durchdringt, denn die Abdeckplatte ist aus einem elektrisch nicht leitfähigen Werkstoff hergestellt.

Folglich entsteht auf der nach außen abstehenden Oberseite der Abdeckplatte ein Kapazitätsfeld. Sobald ein elektrisch leitfähiges Objekt, beispielsweise ein Finger, in den Bereich des Kapazitätsfeldes eindringt, verändert sich der Wert des Kapazitätsfeldes; diese Kapzitätsfeld-Veränderung ist durch die Auswerteeinrichtung feststellbar, so dass dann durch die Auswerteeinrichtung ein elektrisches Schaltsignal erzeugt wird. Da unterhalb der Abdeckplatte eine Vielzahl von Sensoren mit unterschiedlichen Kapazitätsfeldern angeordnet sind, die jeweils einer bestimmten Schaltfunktion zugeordnet sind, ist durch die Auswerteeinrichtung auch ermittelbar, welche gewünschte Schaltfunktion aktiviert werden soll.

Solche Bedienelemente werden in einer Vielzahl von elektrisch betriebenen Geräten zu deren Steuerung eingesetzt und haben sich grundsätzlich in der Praxis bewährt.

Als nachteilig hat es sich nunmehr herausgestellt, dass solche kapazitiven Bedienelemente keine sicherheitsrelevanten Schaltfunktionen übernehmen können, denn an die Aktivierung dieser sicherheitsrelevanten Schaltfunktionen sind erhöhte Anforderungen zu richten. Solche Schaltfunktionen, die sicherheitsrelevante Aspekte erfüllen, werden beispielsweise als Notaus-Taster oder Schalter bezeichnet. Mit Hilfe solcher mechanisch zu betätigenden Tastern, die auch als Kurzhubtaster bezeichnet sind, werden Werkzeugmaschinen im Störungsfalle unverzüglich stillgesetzt und ausgeschaltet.

Die bekannt gewordenen kapazitiven oder auch resistiv betriebenen Schalter können derartige sicherheitsrelevante Schaltfunktionen nicht übernehmen, denn bereits durch das Eindringen eines elektrisch leitfähigen Objektes, beispielsweise Kondenswasser, wird die Schaltfunktion ausgelöst. Dies führt dann zu ungewünschten Stillstandszeiten der Werkzeugmaschinen bzw. stört den Produktionsablauf erheblich.

Es ist daher Aufgabe der Erfindung, ein Bedienelement der eingangs genannten Gattung bereitzustellen, durch das sowohl die üblichen kapazitiven oder resistiven Bedienungen eines elektrischen Gerätes erfolgt und gleichzeitig gewährleistet ist, dass bestimmte sicherheitsrelevante Schaltfunktionen zuverlässig betätigt und ausgeführt werden.

Diese Aufgabe wird erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass zwischen der Abdeckplatte und dem Gehäuserahmen mindestens eine Kraftmesseinrichtung und/oder Wegmesseinrichtung vorgesehen ist bzw. sind, die mit der Auswerteeinrichtung elektrisch verbunden ist, kann durch die Auswerteeinrichtung festgestellt werden, welche Betätigungskraft auf die Abdeckplatte während deren Aktivierung ausgeübt wird. Dies führt dazu, dass mittels der Auswerteeinrichtung feststellbar ist, ob die Betätigungskraft einen vorgegebenen Grenzwert überschreitet und an welcher Position die Betätigungskraft tatsächlich auf die Abdeckplatte einwirkt. Wird demnach durch die Auswerteeinrichtung festgestellt, dass die Betätigungskraft derart groß bemessen ist, dass diese die üblichen Krafteinwirkungsbeträge übersteigt und gleichzeitig an einer Position stattfindet, die einem sicherheitsrelevanten Schaltbereich zugeordnet ist, dann erkennt die Auswerteeinrichtung, dass der Benutzer des Bedienelementes tatsächlich die sicherheitsrelevante Schaltfunktion dieses Schaltbereiches zu aktiveren wünscht und löst anschließend die sicherheitsrelevante Schaltfunktion, beispielsweise Notaus der Werkzeugmaschine, aus.

Vorteilhafterweise können unterschiedliche Funktionsprinzipien für die Kraftmesseinrichtung oder Wegmesseinrichtung eingesetzt werden. Die Kraftmesseinrichtung ist beispielsweise als Dehnmessstreifen, als Piezobaustein oder polymer basiertes Element ausgestaltet, wodurch diese Bauteile Druck- und Zugkräfte, die im Bereich der Kraftmesseinrichtung durch diese hindurch laufen, ermitteln können.

Die Wegmesseinrichtung weist einen Magneten und einen Hallsensor auf, die fluchtend zueinander und beabstandet angeordnet sind, so dass zwischen diesen ein Luftspalt vorherrscht. Sobald auf die Abdeckplatte eine Betätigungskraft ausgeübt ist, verändert sich der Abstand zwischen dem Magneten und dem Hallsensor. Diese Positionsveränderung der Abdeckplatte wird durch den Hallsensor erfasst und wenn ein bestimmter Grenzwert überschritten ist, löst der Hallsensor ein elektrisches Schaltsignal bei der Auswerteeinrichtung aus.

Insbesondere wenn zwischen der Kraftmesseinrichtung und/oder der Wegmesseinrichtung und dem Gehäuserahmen ein Luftspalt vorgesehen ist, erfasst die Kraftmesseinrichtung oder Wegmesseinrichtung einen bestimmten Wert der Betätigungskraft, denn durch die Betätigungskraft wird die Abdeckplatte relativ zu dem Gehäuserahmen in dessen Richtung bewegt, so dass dann eine Druckkraft auf die jeweilige Kraftmesseinrichtung einwirkt bzw. die Wegänderung erkannt wird. Mittels der jeweiligen Kraftmesseinrichtung bzw. Wegmesseinrichtung ist daher der Betrag der Betätigungskraft feststellbar.

Wenn dieser einen vorgegebenen Betrag übersteigt, erkennt die Auswerteeinrichtung, dass der Benutzer tatsächlich die Abdeckplatte mit einer erhöhten Betätigungskraft beaufschlagt hat, wodurch die Freigabe einer sicherheitsrelevanten Schaltfunktion eingeleitet ist. Gleichzeitig ermittelt die Auswerteeinrichtung, an welcher Position die Betätigungskraft tatsächlich aufgebracht ist. Wenn die Betätigungskraft der sicherheitsrelevanten Schaltfunktion zugeordnet werden kann, gibt die Auswerteeinrichtung die sicherheitsrelevante Schaltfunktion frei, wodurch beispielsweise eine Werkzeugmaschine unverzüglich ausgeschaltet wird.

In der Zeichnung sind drei erfindungsgemäße Ausführungsbeispiele dargestellt, die nachfolgend näher erläutert sind. Im Einzelnen zeigt:

Figur 1a    ein erstes Ausführungsbeispiel eines kapazitiv betriebenen Bedienele-mentes mit einem Gehäuserahmen, in dem eine dünnwandige Abdeck-platte eingesetzt ist, mit vier Kraftmesseinrichtungen zwischen der Abdeckplatte und dem Gehäuserahmen und mit einer Auswerteeinrich-tung, die elektrisch mit der jeweiligen Kraftmesseinrichtung und mit ei-nem Sensor zur Erzeugung des Kapazitätsfeldes elektrisch verbunden ist, im Schnitt,

Figur 1b    ein zweites Ausführungsbeispiel eines resistiven betriebenen Bedien-elementes mit einem Gehäuserahmen, in dem eine dünnwandige Ab-deckplatte eingesetzt ist, mit vier Kraftmesseinrichtungen zwischen der Abdeckplatte und dem Gehäuserahmen und mit einer Auswerteeinrich-tung, die elektrisch mit der jeweiligen Kraftmesseinrichtung und mit ei-nem Sensor zur Auswertung des resistiven Bedienelementes elektrisch verbunden ist, im Schnitt,

Figur 2    das Bedienelement gemäß Figur 1 a in Draufsicht,

Figur 3a    ein drittes Ausführungsbeispiel eines kapazitiv betriebenen Bedienele-mentes mit einem Gehäuserahmen, in dem eine dünnwandige Abdeck-platte eingesetzt ist, mit vier Wegmesseinrichtungen zwischen der Abdeckplatte und dem Gehäuserahmen und mit einer Auswerteeinrich- tung, die elektrisch mit der jeweiligen Wegmesseinrichtung und mit ei-nem Sensor zur Erzeugung eines Kapazitätsfeldes elektrisch verbun-den ist, im Schnitt und im unbetätigten Zustand,

Figur 3b    das Bedienelement gemäß Figur 3a, im betätigten Zustand,

Figur 3c    das Bedienelement gemäß Figur 3a, in Draufsicht und

Figur 3d    das Bedienelement gemäß Figur 3a in perspektivischer Ansicht mit ei-nem Auswertungsbeispiel.

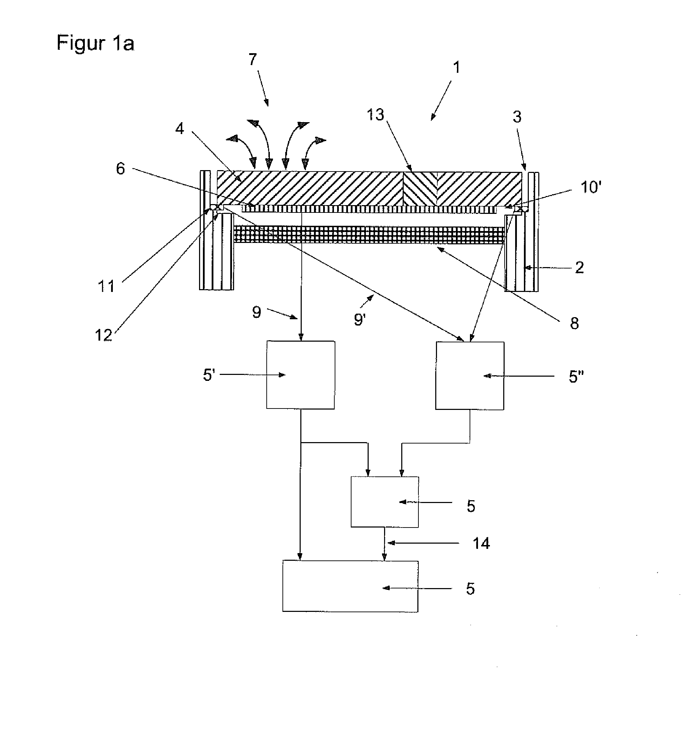

In Figur 1a ist ein Bedienelement 1 zur Erzeugung eines elektrisch auswertbaren Schaltsignales 14 abgebildet. Das Bedienelement 1 besteht aus einem Gehäuserahmen 2, in den eine rechteckförmige Aussparung 3 eingearbeitet ist, in die eine dünnwandige elektrisch nicht leitfähige Abdeckplatte 4, beispielsweise aus Glas oder Kunststoff, eingesetzt ist. Des Weiteren weist das Bedienelement 1 eine als integrier ten Schaltkreis ausgestaltete Auswerteeinrichtung 5 auf, die zur nachfolgend näher erläuterten Funktionsweise der Überwachung des Bedienelementes 1 aus zwei weiteren integrierten Schaltkreisen 5' und 5" besteht und die elektrisch zusammengeschalten sind.

Darüber hinaus ist auf der Innenseite 10' der Abdeckplatte 4 ein Sensor 6 angebracht, der aus einem metallisch leitenden Werkstoff, beispielsweise aus Kupfer, hergestellt ist. Der Sensor 6 ist mit der Auswerteeinrichtung 5 über elektrische Leitungen 9 verbunden und wird durch diese bestromt. Sobald an dem Sensor 6 eine Spannung anliegt, entsteht ein Kapazitätsfeld 7, das auf der Außenseite 10 der Abdeckplatte 4 eine räumliche Ausdehnung einnimmt.

Sobald ein elektrisch leitendes Objekt, beispielsweise der Finger einer menschlichen Hand, in das Kapazitätsfeld 7 eindringt, verändert sich dieses. Der integrierte Schaltkreis 5' ist mit dem Sensor 6 elektrisch gekoppelt, so dass durch diesen die Kapazitätsfeldveränderung ermittelt ist.

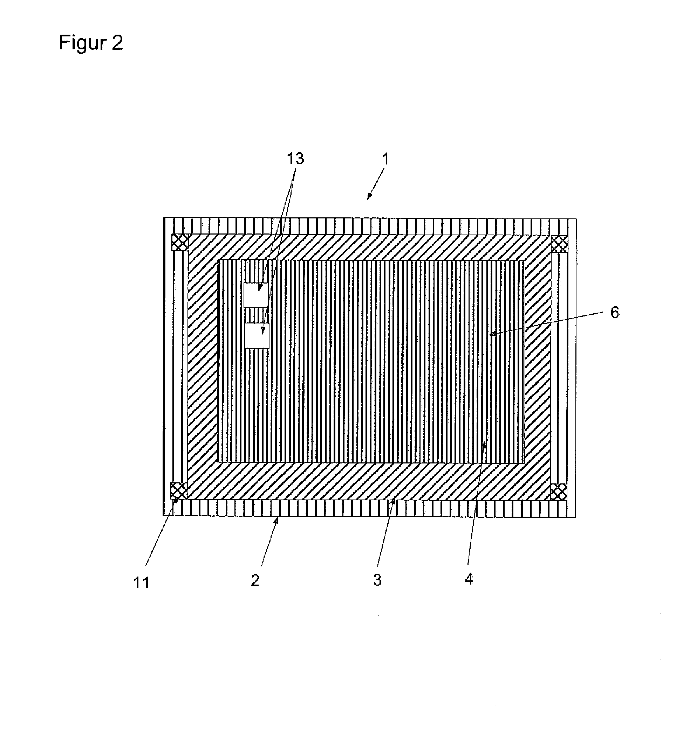

Um nunmehr verifizieren zu können, dass eine ausreichend groß bemessene Betätigungskraft auf die Abdeck-platte 4 einwirkt, sind, und dies kann insbesondere der Figur 2 entnommen werden, in den vier Eckbereichen des Gehäuserahmens 2 jeweils eine Kraftmesseinrichtung 11 angeordnet. Die Kraftmesseinrichtung 11 ist an der Innenseite 10' der Abdeckplatte 4 befestigt. Die Kraftmesseinrichtung 11 kann beispielsweise als Dehnungsmessstreifen, als Piezo oder polymer basiertes Element ausgestaltet sein. Durch diese Kraftmesseinrichtungen 11 werden insbesondere Druckkräfte gemessen, die auf die Abdeckplatte 4 einwirken. Hierbei handelt es sich um die von dem Benutzer aufgebrachte Betätigungskraft.

Der zweite integrierte Schaltkreis 5" ist elektrisch mit jeder der Kraftmesseinrichtungen 11 gekoppelt und ermittelt, ob die Kraftmesseinrichtung 11 eine Druckkraft aufnimmt, welchen Betrag diese Druckkraftkomponente tatsächlich aufweist.

Darüber hinaus sind der Abdeckplatte 4 beispielhaft zwei besondere Schaltbereiche 13 zugeordnet, die eine sicherheitsrelevante Schaltfunktion ausführen sollen, wenn diese betätigt werden. Die Schaltbereiche 13 sind visuell mittels LEDs oder Farbflächen in der Abdeckplatte 4 oder durch ein Display hinter der Abdeckplatte 4 abgebildet.

Die beiden integrierten Schaltkreise 5' und 5'' sind in Form der Auswerteeinrichtung 5 zusammengeschaltet. Durch die Auswerteeinrichtung 5' ist ermittelbar, an welcher Position eine Kapazitätsfeldveränderung 7 auf der Abdeckplatte 4 stattgefunden hat. Dies erfolgt mit dem ersten integrierten Schaltkreis 5' und welcher Betrag der Betätigungskraft auf die Abdeckplatte 4 einwirkt -dies wird durch den zweiten integrierten Schaltkreis 5'' gemessen.

Wenn nunmehr eine ausreichend groß bemessene Betätigungskraft in dem Schaltbereich 13 auf die Abdeckplatte 4 ausgeübt ist, erkennen die beiden integrierten Schaltkreise 5' und 5'' der Auswerteeinrichtung 5 sowohl die Position der Betätigungskraft als auch den Betrag der Betätigungskraft. Sind beide Werte in einem vorgegebenen Schaltbereichen 13 und einem Größenintervall, gibt die Auswerteeinrichtung 5 die Schaltfunktion, die dem Schaltbereich 13 zugeordnet ist, frei. Hierbei handelt es sich beispielsweise um die sicherheitsrelevante Schaltfunktion, eine Werkzeugmaschine unverzüglich anzufahren, stillzusetzen oder auszuschalten.

Sollte die Betätigungskraft an einer Position ausgeübt werden, die keine sicherheitsrelevante Schaltfunktion aufweist, gibt die Auswerteeinrichtung 5 diese Schaltfunktion nicht frei, auch wenn die Betätigungskraft ausreichend groß auf die Abdeckplatte 4 aufgebracht ist.

Folglich kann auch verhindert werden, dass Kapazitätsfeldstörungen, die ungewünscht sind, eine Fehlfunktion der Werkzeugmaschine auslösen. Wenn beispielsweise ein Wassertropfen auf einem Schaltbereich 13 vorhanden ist und dadurch das Kapazitätsfeld 7 verändert wird, erkennt der zweite integrierte Schaltkreis 5'', dass keine ausreichend groß bemessene Betätigungskraft ausgeübt ist, wodurch verhindert wird, dass die sicherheitsrelevante Schaltfunktion ausgeführt wird.

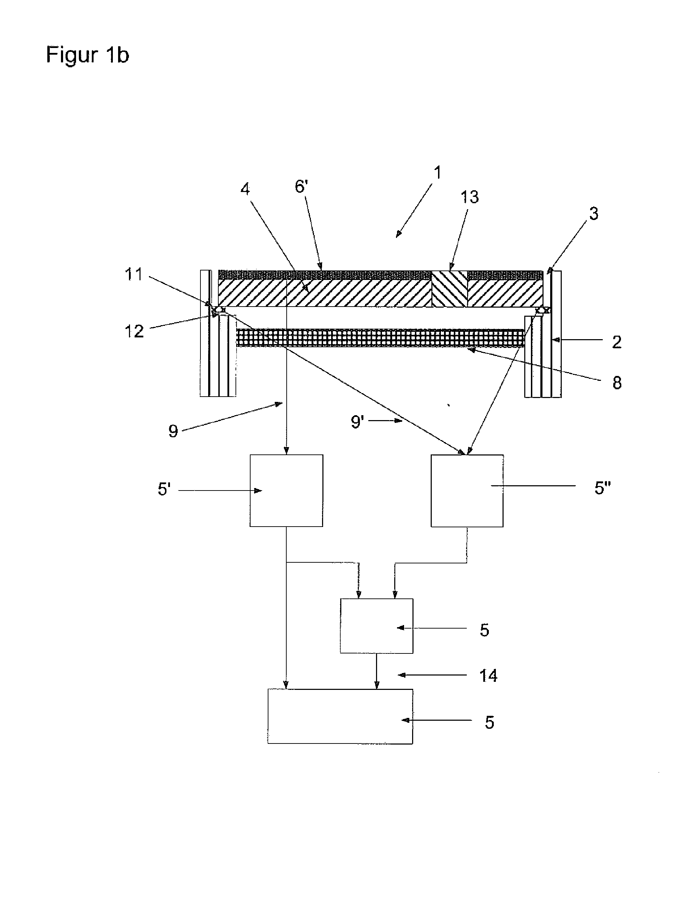

In Figur 1b ist das Bedienelement 1 mit einem resistiven Sensor 6' ausgerüstet. Die elektrische Widerstandsveränderung auf der Abdeckplatte 4 wird folglich über den ersten integrierten Schaltkreis 5', ähnlich wie bei der Kapazitätsfeldveränderung 7, nach der im Ausführungsbeispiel der Figur 1a, erfasst. Der Abfragezyklus hinsichtlich der Freigabe der sicherheitsrelevanten Schaltfunktion erfolgt in identischer Weise, denn erst wenn die Druckkraftkomponente die auf die Abdeckplatte 4 und den vorgegebenen Schaltbereich 13 einwirkt, einen ausreichend großen Kraftbetrag aufweist und die Betätigungskraft exakt an der Position ausgeübt ist, die dem Schaltbereich 13 als sicherheitsrelevante Schaltfunktion zugeordnet ist, erfolgt durch die Auswerteeinrichtung 5 die Freigabe des Schaltsignals 14.

Es ist auch vorstellbar, dass zwischen der Kraftmesseinrichtung 11 und dem Gehäuserahmen 2 ein Luftspalt 12 vorgesehen ist und dass die Abdeckplatte 4 relativ zu dem Gehäuserahmen 2, insbesondere gegen die Kraft einer Schrauben-Druckfeder, bewegt werden kann. Sobald dann der Luftspalt 12 überwunden ist, wirkt die Betätigungskraft nicht nur auf die Abdeckplatte 4 sondern auch auf die einzelnen Kraftmesseinrichtungen 11 ein, wodurch diese eine entsprechende Druckkraftkomponente gemessen wird.

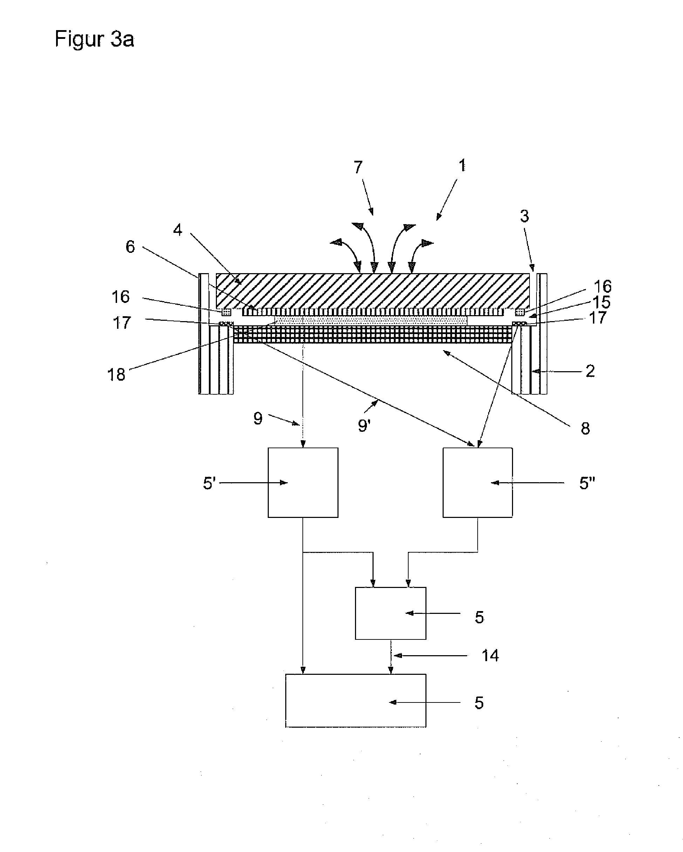

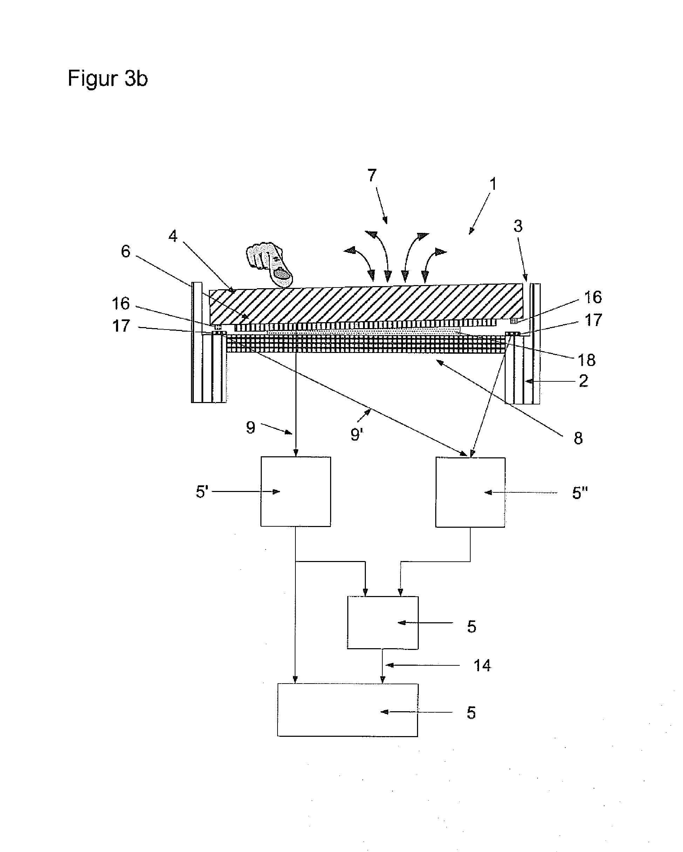

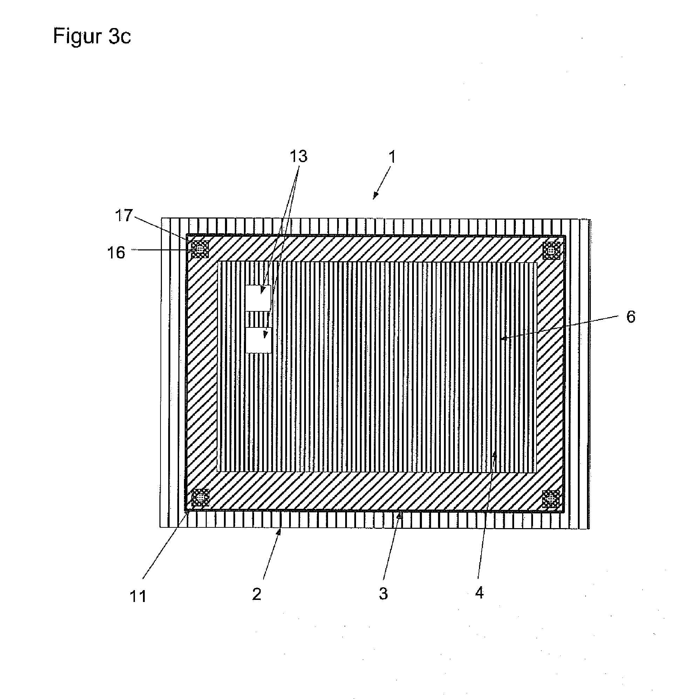

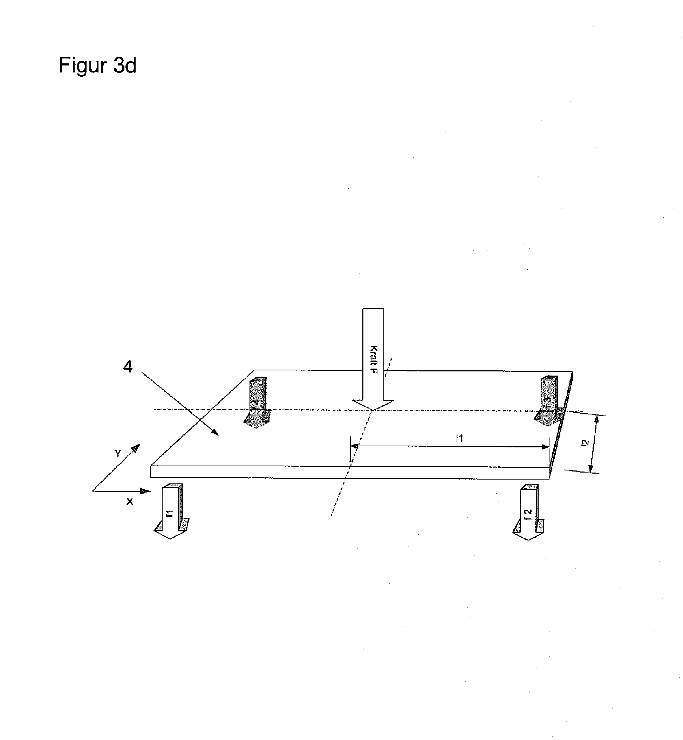

In den Figuren 3a, 3b und 3c ist das Bedienelement 1 mit vier Wegmesseinrichtungen 15 ausgerüstet. Die Wegmesseinrichtung 15 besteht jeweils aus einem an der Innenseite 10' der Abdeckplatte 4 angebrachten Magnet 16 und einem zu diesem beabstandeten und fluchtend angeordneten Hallsensor 17, der an dem Gehäuserahmen 2 fixiert ist. Die Abdeckplatte 4 ist relativ zu dem Gehäuserahmen 2 an diesem gelagert, so dass die Abdeckplatte 4 nach Art eines Kurzhubtasters in Richtung der Hallsensoren 17 bewegt werden kann.

Zwischen dem Gehäuserahmen 2 ist gemäß Figur 3a eine Abdeckplatte 4 mit einer Anzeige 8 fest angebracht, auf der Symbole und dgl. aufgedruckt sind und die mittels Lichtwellen oder anderen optischen Hilfsmitteln durch die Abdeckplatte 4 hindurch erkennbar sind. Zwischen der Anzeige 8 und der Unterseite der Abdeckplatte 4 ist ein elastisch verformbares Verbindungsmaterial 18 vorgesehen, dessen Funktion darin besteht, die Abdeckplatte 4 gegenüber dem Gehäuserahmen 2 federnd abzustützen. Sobald nämlich die Betätigungskraft auf die Abdeckplatte 4 einwirkt, wird das Verbindungsmaterial 18 zusammengedrückt, so dass durch dieses eine entgegen der Betätigungskraft wirkende Rückstellkraft entsteht. Beim Herunterdrücken der Abdeckplatte 4 ist somit die Widerstandskraft des Verbindungsmateriales 18 zu überwinden, um überhaupt eine Abstandsveränderung zwischen dem Magneten 16 und dem Hallsensor 17 zu erreichen. Folglich ist mittels des Verbindungsmaterials 18 sichergestellt, dass erst bei ausreichend groß bemessener Betätigungskraft eine Abstandsverkleinerung zwischen dem Magneten 16 und dem Hallsensor 17 erfolgt.

In Figur 3b ist eine mathematische Auswertemöglichkeit gezeigt, denn durch die Wegmesseinrichtung 15 soll sowohl die Position als auch der Kraftbetrag der Betätigungskraft unabhängig voneinander messbar sein, so dass mittels der Auswerteeinrichtung 5 festgestellt werden kann, ob exakt auf dem Bereich der Abdeckplatte 4, der dem Schaltbereich 13 entspricht, einwirkt und ob die Betätigungskraft ausreichend groß ausgeübt ist.

Dabei ist die Abdeckplatte 4 in das übliche X-Y-Koordinatensystem unterteilt. Die Position der Betätigungskraft in X- und Y-Koordinaten wird mittels den nachfolgend abgebildeten Formeln errechnet:

$$x = \frac{\left(-f1 \times l1 + f2 \times l1 + f3 \times l1 - f4 \times l1\right)}{F} = l1 \times \frac{f2 + f3 - f1 - f4}{f1 + f2 + f3 + f4}$$

$$y = \frac{\left(-f1 \times l2 - f2 \times l2 + f3 \times l2 + f4 \times l2\right)}{F} = l2 \times \frac{f2 + f4 - f1 - f2}{f1 + f2 + f3 + f4}$$

Mittels einer ausreichend groß bemessenen Betätigungskraft ist somit die Abdeckplatte 4 und die an dieser angebrachten Magneten 16 in Richtung der jeweiligen Hallsensoren 17 bewegbar. Sobald der Abstand zwischen den Magneten 16 und den Hallsensoren 17 verkleinert ist, verändert sich die Ausgangsspannung der Hallsensoren 17. Diese Spannungsveränderung ist von der Auswerteeinrichtung 5" feststellbar. Gemäß den mathematischen Formeln kann dann durch die Auswerteeinrichtung eine Positionsbestimmung der Betätigungskraft errechnet werden. Um nunmehr die Redundanz des Bedienelementes 1 zu erhöhen, ist die ermittelte Position der Betätigungskraft von der Auswerteeinrichtung 5" mit der Positionsinformation der Auswerteeinrichtung 5' zu vergleichen, um bei Übereinstimmung ein entsprechendes Schaltsignal durch die Auswerteeinrichtung 5 zu generieren. Weichen die Positionsbestimmungen voneinander ab, erfolgt durch die Auswerteeinrichtung 5 kein Schaltsignal.

**Patentansprüche**

**1.** Bedienelement (1) zur Erzeugung eines elektrisch auswertbaren Schaltsignals (14), bestehend aus einem Gehäuserahmen (2), aus einer dünnwandigen Abdeckplatte (4), die in den Gehäuserahmen (2) eingesetzt und an diesem abgestützt ist, aus einer elektrisch betriebenen Auswerteeinrichtung (5, 5', 5") und aus mindestens einem der Abdeckplatte (4) zugewandten Sensor (6), der durch die Auswerteeinrichtung (5, 5', 5") überwacht ist und durch den ein kapazitives Feld (7) oder resistive Veränderung (8) erzeugt ist, das auf der Außenseite (10) der Abdeckplatte (4) gebildet ist,
**dadurch gekennzeichnet,**
**dass** der Abdeckplatte (4) mindestens ein Schaltbereich (13) zugeordnet ist, der eine vorgegebene Schaltfunktion aufweist, dass zwischen dem Gehäuserahmen (2) und der diesem zugewandten Innenseite (10') der Abdeckplatte (4) mindestens eine Kraftmesseinrichtung (11) und/oder eine Wegmesseinrichtung (15) angeordnet ist, die elektrisch mit der Auswerteeinrichtung (5") derart verbunden ist bzw. sind, dass durch die Auswerteeinrichtung (5") feststellbar ist, an welcher Position der Abdeckplatte (4) eine Betätigung erfolgt und dass durch die Auswerteeinrichtung (5") über die Kraftmesseinrichtung (11) und/oder Wegmesseinrichtung (15) ermittelbar ist, welche Betätigungskraft an dieser Position auf die Abdeckplatte (4) einwirkt.

**2.** Bedienelement nach Anspruch 1,
**dadurch gekennzeichnet,**
**dass** die Schaltbereiche (13) zur Bildung von besonderen Schaltfunktionen mittels visuell von außen sichtbaren Elementen, vorzugsweise auf der Abdeckplatte eingearbeitete Symbole und/oder unter der Abdeckplatte (4) angeordnete Leuchtmittel, gebildet sind.

**3.** Bedienelement nach Anspruch 1 oder 2,
**dadurch gekennzeichnet,**
**dass** die Kraftmesseinrichtung (11) als Dehnmessstreifen, als Piezo-Baustein oder als polymer basiertes Element ausgestaltet ist.

**4.** Bedienelement nach Anspruch 1 oder 2,
**dadurch gekennzeichnet,**
**dass** die Wegmesseinrichtung (15) aus einem Magneten (16) und aus einem Hallsensor (17) gebildet ist und dass der Abstand zwischen dem Magneten (16) und dem Hallsensor (17) durch die Auswerteeinrichtung (5") überwacht ist.

**5.** Bedienelement nach einem der vorgenannten Ansprüche,
**dadurch gekennzeichnet,**
**dass** die Kraftmesseinrichtung (11) an der Abdeckplatte (4) befestigt ist und dass zwischen der Kraftmesseinrichtung (11) und dem Gehäuserahmen (2) ein Luftspalt (12) vorgesehen ist.

**6.** Bedienelement nach Anspruch 3,
**dadurch gekennzeichnet,**
**dass** zwischen dem Magneten (16) und dem Hallsensor (17) ein Luftspalt (12) vorgesehen ist, dass der Magnet (16) an der Abdeckplatte (4) befestigt ist und dass der Hallsensor (17) an dem Gehäuserahmen (2) angebracht ist.

**7.** Bedienelement nach Anspruch 5,
**dadurch gekennzeichnet,**
**dass** der Luftspalt (12) zwischen jeder Kraftmesseinrichtung (11) und jedem Gehäuserahmen (2) gleich groß bemessen ist.

**8.** Bedienelement nach einem der vorgenannten Ansprüche,
**dadurch gekennzeichnet,**
**dass** die Kraftmesseinrichtung (11) bzw. Wegmesseinrichtung (15) in dem jeweiligen Eckbereich der Abdeckplatte (4) angeordnet ist.

**9.** Bedienelement nach einem der vorgenannten Ansprüche,
**dadurch gekennzeichnet,**
**dass** die Abdeckplatte (4) relativ zu dem Gehäuserahmen (2) beweglich gelagert ist und dass durch die auf die Abdeckplatte (4) einwirkende Betätigungskraft eine auf die jeweilige Kraftmesseinrichtung (11) aufzunehmende Druckkraftkomponente bzw. bei der Wegmesseinrichtung (15) eine Abstandsänderung zwischen der Innenseite (10') und der Wegmesseinrichtung (15) entsteht.

**10.** Bedienelement nach Anspruch 1,
**dadurch gekennzeichnet,**
das zwischen der Abdeckplatte (4) und dem Gehäuserahmen (2) ein elastisches Verbindungsmaterial (18) angeordnet ist, dass durch das Verbindungsmaterial (18) eine der Betätigungskraft entgegenwirkende Kraft gebildet ist, die durch die Betätigungskraft zur Abstandsveränderung zwischen der Abdeckplatte (4) und dem Gehäuserahmen (2) zu überwinden ist.

Figur 1a

Figur 1b

Figur 2

Figur 3a

## Figur 3b

## Figur 3c

Figur 3d

EP 2 492 786 A1

**EUROPÄISCHER RECHERCHENBERICHT**

Nummer der Anmeldung

EP 11 15 5357

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2010/106759 A1 (SONY CORP [JP]; KANEHIRA HIROKI [JP]; HONDA HIDETOSHI [JP]; ISHIGAKI M) 23. September 2010 (2010-09-23) * Abbildungen 1-21 * & US 2011/157087 A1 (KANEHIRA HIROKI [JP] ET AL) 30. Juni 2011 (2011-06-30) * Absatz [0003] * * Absatz [0007] * * Absatz [0008] - Absatz [0019] * * Absatz [0028] - Absatz [0031] * * Absatz [0069] - Absatz [0084] * * Absatz [0095] - Absatz [0098] * ----- | 1-10 | INV. G06F3/044 G06F3/041 |
| A | JP 2000 346606 A (TOTOKU ELECTRIC) 15. Dezember 2000 (2000-12-15) * Zusammenfassung * * Abbildungen 1,2,4 * ----- | 4-6 | |
| A | US 2004/156168 A1 (LEVASSEUR LEWIS H [CA] ET AL) 12. August 2004 (2004-08-12) * Zusammenfassung * * Abbildungen 1-4,6-14 * * Absatz [0004] - Absatz [0005] * * Absatz [0053] * * Absatz [0060] - Absatz [0062] * * Absatz [0059] * ----- | 1-10 | RECHERCHIERTE SACHGEBIETE (IPC) G06F H03K |
| A | US 2002/149571 A1 (ROBERTS JERRY B [US]) 17. Oktober 2002 (2002-10-17) * Zusammenfassung * * Abbildungen 1,2,4,6-8 * * Absatz [0050] * * Absatz [0054] - Absatz [0055] * ----- -/-- | 1-10 | |

Der vorliegende Recherchenbericht wurde für alle Patentansprüche erstellt

| Recherchenort | Abschlußdatum der Recherche | Prüfer |
|---|---|---|
| Den Haag | 29. November 2011 | Mouanda, Thierry |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

14

Europäisches
Patentamt

European
Patent Office

Office européen
des brevets

**EUROPÄISCHER RECHERCHENBERICHT**

**Nummer der Anmeldung**

EP 11 15 5357

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2008/202824 A1 (PHILIPP HARALD [IE] ET AL) 28. August 2008 (2008-08-28) <br> * Zusammenfassung * <br> * Abbildungen 1-17 * <br> * Absatz [0022] * <br> * Absatz [0033] - Absatz [0034] * <br> ----- | 1-10 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| Den Haag | 29. November 2011 | Mouanda, Thierry |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 11 15 5357

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-11-2011

| Im Recherchenbericht angeführtes Patentdokument | Datum der Veröffentlichung | Mitglied(er) der Patentfamilie | Datum der Veröffentlichung |
|---|---|---|---|
| WO 2010106759 A1 | 23-09-2010 | CN 102138120 A<br>JP 2010244514 A<br>US 2011157087 A1<br>WO 2010106759 A1 | 27-07-2011<br>28-10-2010<br>30-06-2011<br>23-09-2010 |
| JP 2000346606 A | 15-12-2000 | KEINE | |
| US 2004156168 A1 | 12-08-2004 | AU 2003300047 A1<br>CN 1748197 A<br>EP 1593032 A2<br>JP 2006514367 A<br>KR 20050107424 A<br>US 2004156168 A1<br>WO 2004072842 A2 | 06-09-2004<br>15-03-2006<br>09-11-2005<br>27-04-2006<br>11-11-2005<br>12-08-2004<br>26-08-2004 |
| US 2002149571 A1 | 17-10-2002 | CN 1527933 A<br>EP 1428004 A2<br>JP 2004531716 A<br>US 2002149571 A1<br>US 2002163509 A1<br>US 2002180710 A1<br>WO 02084244 A2 | 08-09-2004<br>16-06-2004<br>14-10-2004<br>17-10-2002<br>07-11-2002<br>05-12-2002<br>24-10-2002 |
| US 2008202824 A1 | 28-08-2008 | CN 101373413 A<br>DE 102008008921 A1<br>DE 202008001970 U1<br>GB 2446702 A<br>JP 2008198205 A<br>KR 20080075804 A<br>TW 200844825 A<br>US 2008202824 A1 | 25-02-2009<br>04-09-2008<br>21-05-2008<br>20-08-2008<br>28-08-2008<br>19-08-2008<br>16-11-2008<br>28-08-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 10155169 A